# EUROPEAN PATENT APPLICATION

(11) **EP 4 756 068 A1**
(43) Date of publication of application: **10.06.2026**
(21) Application number: 25169606.8
(22) Date of filing: 10.04.2025
(51) Int. Cl.: C23C 10/28, C23C 10/30, C23C 10/02, C23C 10/60, A01N 59/00, C23C 14/02, C23C 14/58, C23C 16/02, C23C 16/56, C25D 5/48, C25D 5/50, C23C 28/00, C23C 28/02

(54) **METHOD FOR PREPARING ANTIBACTERIAL SILVER-CONTAINING STAINLESS STEEL BY SURFACE ALLOYING**

(30) Priority: 06.12.2024 TW 113147556
(71) Applicant: Tung Mung Development Co., Ltd., Tainan City 726 (TW)
(72) Inventor: Liu, Bernard Haochih, 701037 Tainan City (TW); Tsai, Wen-Ta, 701041 Tainan City (TW); Lu, Yen-Chieh, 830514 Kaohsiung City (TW); Yang, Chiao-Fen, 726 Tainan City (TW); Chen, Zhi-Yan, 427004 Taichung City (TW); Huang, Chong-Cheng, 710026 Tainan City (TW)
(74) Representative: Jannig & Repkow Patentanwälte PartG mbB

(57) **Abstract**

This disclosure provides a method for preparing antibacterial silver-containing stainless steel through surface alloying, which includes: coating at least one diffusion-assisted medium layer on the surface of the stainless steel; coating at least one silver-containing antibacterial metal layer on the diffusion-assisted medium layer, wherein the silver concentration in the antibacterial metal layer is at least 0.2 wt% or higher; Heat treatment is then performed on the stainless steel to enable the diffusion of the silver antibacterial metal into the stainless steel; As a result, a silver antibacterial alloy layer is formed on the surface of the stainless steel, imparting antibacterial properties and significantly enhancing its corrosion resistance. Additionally, this method is universally applicable to various types of stainless steel and allows for adjustment the concentration of antibacterial alloying elements and the thickness of the alloy layer through process parameter modifications, making it adaptable to different applications and providing broad applicability.

## Description

### BACKGROUND OF THE DISCLOSURE

### Technical Field

The present disclosure provides a method for preparing antibacterial silver-containing stainless steel through surface alloying, specifically involving the coating of a silver-containing antibacterial metal layer onto the surface of stainless steel, followed by heat treatment to diffuse the silver atoms into the stainless steel, thereby forming a silver-containing antibacterial alloy layer with a defined thickness. This disclosure not only preserves the mechanical properties of stainless steel, but also imparts excellent corrosion resistance and antibacterial properties.

### Description of the Related Art

Stainless steel is widely used in household products, kitchenware and medical equipment due to its aesthetic appeal and excellent corrosion resistance. With the increasing awareness of hygiene and safety, stainless steel with antibacterial functionality has garnered increasing attention. Currently, the antibacterial technologies for stainless steel can be broadly categorized into two main types: (a) surface coating types, and (b) alloy-based types.

Among them, the surface coating type achieves the antibacterial effect by applying antibacterial substances onto the surface of stainless steel, and the durability of its antibacterial performance depends on the adhesion and thickness of the coating. However, during use, the antibacterial effect gradually diminishes as the coating wears away, eventually disappearing when the antibacterial substances are depleted. In contrast, the alloy-based technology incorporates antibacterial elements directly into the stainless steel substrate, offering superior antibacterial durability. The antibacterial effect is closely related to the content, composition and distribution of the antibacterial elements. Due to the common issues such as coating delamination and insufficient wear resistance in surface-coated products, the market is currently dominated by alloy-based antibacterial stainless steel products.

The alloy-type antibacterial stainless steel products currently available in the market are primarily manufactured through melting; This method involves mixing antibacterial elements with the stainless steel substrate at high temperatures, allowing the antibacterial elements to be homogeneously solidified within the substrate. As a result , the entire stainless steel exhibits uniform antibacterial properties. The advantage of this process is that the antibacterial elements are evenly distributed in the stainless steel, ensuring consistent antibacterial properties across the material. However, although the antibacterial mechanism primarily acts on the surface of the material, a large amount of antibacterial elements is required to ensure sufficient overall concentration. This is not only significantly increasing the cost of raw materials, but also alters the original mechanical properties of the material, which in turn poses challenges for subsequent processing. For example, it is more challenging to use ferritic steel, martensitic steel and other types of steel to produce antibacterial products with suitable properties using this technology.

To address the above issues, a preparation method for surface alloy-type stainless steel has been developed; This technology typically employs techniques such as ion implantation or shot peening, etc. for the surface treatment of stainless steel. By modifying the steel surface, an antibacterial alloy layer with a specific thickness is formed, imparting antibacterial properties and durability to the stainless steel without altering the mechanical properties of the substrate. However, these process methods are not widely adopted because of their high cost and the challenges associated with mass production.

In response to the above challenges, the discloser of the present disclosure has filed and obtained the R.O.C. Patent No. I17863 entitled "Method of Preparing Antibacterial Stainless Steel by Surface Alloying", which is primarily based on the specialized design of an auxiliary medium to enable copper to be successfully and effectively diffused to the surface of stainless steel during heat treatment, forming an antibacterial alloy layer. However, compared to copper, the solid solubility of silver in stainless steel is extremely low, making it impractical to diffuse silver to the surface of stainless steel using this method. This presents greater technical challenges in developing silver-based antibacterial stainless steel products. Since silver possesses excellent antibacterial properties and is generally regarded as a noble material by consumers, it offers superior market potential. Consequently, developing effective method to diffuse silver into stainless steel has become a critical issue that requires immediate attention and viable solutions.

In view of the above, the discloser of this disclosure has dedicated efforts to studying silver diffusion in stainless steel and antibacterial treatment on stainless steel surface. Through extensive research and experimentation to address the aforementioned challenges, the inventor ultimately developed the method described in the present disclosure.

### SUMMARY OF THE DISCLOSURE

The primary objective of the present disclosure is to address the aforementioned issues and achieve the intended objective by providing a method for preparing antibacterial silver-containing stainless steel through surface alloying. This method comprises the following steps: coating at least one diffusion-assisted medium layer on a surface of stainless steel; coating at least one silver-containing antibacterial metal layer on the diffusion-assisted medium layer, wherein the silver concentration of the silver antibacterial metal layer is at least 0.2 wt%; and performing heat treatment on the stainless steel to diffuse the silver antibacterial metal into the stainless steel.

In the method for preparing antibacterial silver-containing stainless steel through surface alloying, the diffusion-assisted medium layer (Infiltration promoter layer) has a thickness falling within a range from 0.05 µm to 5.00 µm.

In the method for preparing antibacterial silver-containing stainless steel through surface alloying, the silver antibacterial metal layer has a thickness falling within a range from 0.02 µm to 2.00 µm.

In the method for preparing antibacterial silver-containing stainless steel through surface alloying, the heat treatment is conducted at a temperature of 500°C or higher in a protective atmosphere for a duration exceeding 1 min., followed by cooling to room temperature upon completion of the heat treatment.

In the method for preparing antibacterial silver-containing stainless steel through surface alloying, after the heat treatment, the material is cooled to room temperature by furnace cooling, air cooling, quenching, or any combination of the above.

In the method for preparing antibacterial silver-containing stainless steel through surface alloying, the diffusion-assisted medium layer (Infiltration promoter layer) is copper, cobalt, nickel, zinc, molybdenum, chromium, titanium, or any combination of the above.

In the method for preparing antibacterial silver-containing stainless steel through surface alloying, the stainless steel is ferritic stainless steel, austenitic stainless steel, martensitic stainless steel, duplex stainless steel, or any combination of the above.

In the method for preparing antibacterial silver-containing stainless steel through surface alloying, the diffusion-assisted medium layer (Infiltration promoter layer)or the silver antibacterial metal layer is coated by physical vapor deposition, chemical vapor deposition, electroplating, autocatalytic plating, or any combination of the above.

In the method for preparing antibacterial silver-containing stainless steel through surface alloying, the diffusion-assisted medium layer (Infiltration promoter layer) and the silver antibacterial metal layer are coated on the surface of stainless steel by multi-layer stacking.

In the method for preparing antibacterial silver-containing stainless steel through surface alloying, the diffusion-assisted medium layer and the silver antibacterial metal layer are coated on the surface of stainless steel simultaneously by co-deposited coating.

From the above description and configuration, it is evident that the present disclosure has the advantages and functions as described in detail below.

1. The present disclosure is applicable to various types of stainless steel, through the coating of the silver antibacterial metal layer and performing heat treatment, the silver antibacterial metal can be diffused and solid-solved into the stainless steel. Compared with the applicant's previous application for R.O.C. Patent No. 17863, the present disclosure enables the diffusion of silver (Ag) element, which has superior antibacterial properties, onto the surface of stainless steel, forming a silver-containing antibacterial alloy layer. This approach not only enhance electrochemical performance but also significantly improves the corrosion resistance of the original substrate material. Through the diffusion-assisted medium layer (Infiltration promoter layer), the silver element can be effectively diffused into the stainless steel substrate, resulting in a microstructure distinct from that of copper-containing stainless steel. The present disclosure is applicable to austenitic stainless steel, ferritic stainless steel and martensitic stainless steel. Moreover, process parameters can be adjusted to control the chemical composition, thickness, and grain size of the silver-containing antibacterial alloy layer, enabling customization for different applications and enhancing the applicability and performance of the present disclosure.

### BRIEF DESCRIPTION OF THE DRAWINGS

FIG. 1 is a flow chart the present disclosure;
FIG. 2a is an SEM micrograph showing the cross-sectional microstructure of Sample No. 1 (420J2 SS) from the present disclosure prior to heat treatment;
FIG. 2b is an SEM micrograph showing the cross-sectional microstructure of Sample No. 1 (420J2 SS) from the present disclosure after heat treatment;
FIG. 2c is an SEM micrograph showing the surface microstructure of Sample No. 1 (420J2 SS) from the present disclosure after heat treatment;
FIG. 2d is an SEM micrograph showing the cross-sectional microstructure of Sample No. 10 (420J2 SS) from the present disclosure after heat treatment;
FIG. 3 is a comparative diagram illustrating the effect of a diffusion-assisted medium layer on silver diffusion in 420J2 stainless steel, as demonstrated in an embodiment of the present disclosure. In the diagram, Sample No. 1 on the left applies a diffusion-assisted medium layer, while Sample No. 10 on the right does not utilize any diffusion-assisted medium layer;
FIG. 4a is an SEM micrograph showing the cross-sectional microstructure of Sample No. 2 (304L SS) from the present disclosure prior to heat treatment ;
FIG. 4b is an SEM micrograph showing the cross-sectional microstructure of Sample No. 2 (304L SS) from the present disclosure after heat treatment;
FIG. 4c is an SEM micrograph showing the surface microstructure of Sample No. 2 (304L SS) from the present disclosure after heat treatment;
FIG. 4d is an SEM micrograph showing the cross-sectional microstructure of Sample No. 11 (304L SS) from the present disclosure after heat treatment;
FIG. 5 is a comparative diagram illustrating the effect of a diffusion-assisted medium layer on silver diffusion in 304L stainless steel, as demonstrated in an embodiment of the present disclosure. In the diagram, Sample No. 2 on the left applies a diffusion-assisted medium layer, while Sample No. 11 on the right does not utilize any diffusion-assisted medium layer;
FIG. 6 is a comparative diagram illustrating the effect of diffusion-assisted medium layers with varying thicknesses on silver diffusion depth in 304L stainless steel, as demonstrated in an embodiment of the present disclosure. The thicknesses of the diffusion-assisted medium layers are as follows: 0.40 µm for Sample No. 3, 0.50 µm for Sample No. 4, and 0.60 µm for Sample No. 5;
FIG. 7 is a comparative diagram illustrating the effect of different heat treatment conditions on the silver diffusion structure in 420J2 stainless steel, as demonstrated in an embodiment of the present disclosure. In the diagram, Sample No. 1 on the left is maintained at 800°C for 2 hours, while Sample No. 6 on the right is maintained at 900°C for 2 hours;
FIG. 8 is a comparative diagram illustrating the effect of different heat treatment conditions on the silver diffusion structure in 304L SS, as demonstrated in an embodiment of the present disclosure. In the diagram, Sample No. 2 is maintained at 800°C for 2 hours, Sample No. 3 is maintained at 900°C for 2 hours, and Sample No. 7 is maintained at 900°C for 5 hours;
FIG. 9 is a surface image of Sample No. 8 (420J2 SS) from an embodiment of the present disclosure after polishing;
FIG. 10 presents the antibacterial test results of Sample No. 8 (420J2 SS) from an embodiment of the present disclosure, where Sample No. 12 serves as a control sample without antibacterial treatment;
FIG. 11 shows the surface images of Samples No. 3, No. 4, and No. 5 of 304L SS from an embodiment of the present disclosure after polishing. The thicknesses of the diffusion-assisted medium layers used for each sample are as follows: 0.40 µm for Sample No. 3, 0.50 µm for Sample No. 4, and 0.60 µm for Sample No. 5;
FIG. 12 shows the antibacterial test results of Samples No. 3, No. 4, and No. 5 of 304L stainless steel from an embodiment of the present disclosure. The thicknesses of the diffusion-assisted medium layers used for each sample are as follows: 0.40 µm for Sample No. 3, 0.50 µm for Sample No. 4, and 0.60 µm for Sample No. 5;
FIG. 13 is a comparative diagram showing the cyclic polarization measurements of 420J2 SS from an embodiment of the present disclosure after silver diffusion. In this diagram, Samples No. 8 and No. 9 are both treated with silver antibacterial treatment, with Sample No. 8 having a 0.30 µm diffusion-assisted medium layer and Sample No. 9 having a 0.40 µm diffusion-assisted medium layer. Sample No. 12, in contrast, is a hardened 420J2 material without silver antibacterial treatment;
FIG. 14 is a comparative diagram showing the cyclic polarization measurements of 304L SS from an embodiment of the present disclosure after silver diffusion. In this diagram, Samples No. 3, No. 4, and No. 5 are treated with silver antibacterial treatment, with Sample No. 3 having a 0.30 µm diffusion-assisted medium layer, Sample No. 4 having a 0.40 µm diffusion-assisted medium layer, and Sample No. 5 having a 0.50 µm diffusion-assisted medium layer. In contrast, Sample No. 13 is a 304L material without silver antibacterial treatment.

### DESCRIPTION OF THE PREFERRED EMBODIMENTS

With respect to the technical means of the present disclosure, several preferred embodiments are described in detail below in conjunction with the drawings to provide a deeper understanding and a better recognition of the present disclosure.

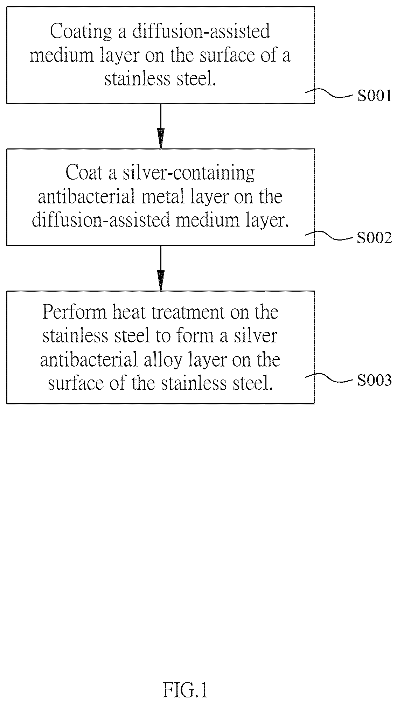

With reference to FIG. 1 for a method for preparing antibacterial silver-containing stainless steel by surface alloying in accordance with the present disclosure, the method includes the following steps:

S001: At least one diffusion assisted medium (infiltration promoter) layer is coated on the surface of stainless steel, in which the diffusion-assisted medium layer of an embodiment is made copper, cobalt, nickel, zinc, molybdenum, chromium, titanium or any combination of the above; the stainless steel of a specific embodiment is ferritic stainless steel, austenitic stainless steel, martensitic stainless steel, duplex stainless steel, or any combination of the above; the coating of diffusion-assisted medium layer on the surface of stainless steel in an embodiment is carried out by means of physical vapor deposition, chemical vapor deposition, electroplating, autocatalytic plating or any combination of the above; however, the foregoing are examples for illustrating the present disclosure only, but are not intended for limiting the present disclosure; and the stainless steel serving as the substrate can be of any structure or form such as blocks, plates, semi-finished products, etc.

As for the diffusion-assisted medium layer, its thickness can be arbitrary, and preferably falls within a range between 0.05 µm and 5 µm. If the thickness of the diffusion-assisted medium layer is insufficient, it may not be able to promote the diffusion of metallic elements effectively; and if the thickness of the diffusion-assisted medium layer is more than 5.00 µm, it may hinder the diffusion of the silver antibacterial metal later.

S002: At least one silver-containing antibacterial metal layer is coated on the diffusion-assisted medium layer, in which the silver concentration of the silver antibacterial metal layer is at least 0.2 wt%; it is known that the silver antibacterial metal layer can be coated with the diffusion-assisted medium first and then the silver antibacterial metal layer, such that the diffusion-assisted medium is located between the silver antibacterial metal layer and the stainless steel, and in other embodiment, the silver antibacterial metal layer is coated between the diffusion-assisted medium layer and the stainless steel; it is understood that the position of the silver antibacterial metal layer is not limited to the upper or lower end of the diffusion-assisted medium layer relative to the stainless steel; As to the coating of the silver antibacterial metal layer, it is the same as above, and in other embodiments, the coating can be carried out by means of physical vapor deposition, chemical vapor deposition, electroplating, autocatalytic plating, or any combination of the above.

In the coating of the silver antibacterial metal layer, its thickness can be configured according to requirements, and the thickness of the silver antibacterial metal layer falls within a range from 0.02 µm to 2.00 µm; if the thickness of the silver antibacterial metal layer is less than 0.02 µm, it will be difficult to form a sufficiently concentrated silver alloy layer on the surface of stainless steel to ensure a good antibacterial effect; and if the thickness of the silver antibacterial metal layer exceeds 2.00 µm, the excess antibacterial layer may exist on the surface of stainless steel as silver residue, which needs to be removed by additional surface treatment.

In addition to the aforementioned coating sequence, in other embodiments, the diffusion-assisted medium layer and the silver antibacterial metal layer, can be coated on the surface of stainless steel by multi-layer stacking. In other words, at least one of the diffusion-assisted medium layer and the silver antibacterial metal layer can be configured with multiple layers, so that they can be overlapped with each other, for example, when there are multiple diffusion-assisted medium layers and silver antibacterial metal layers, they can be arranged into four layers in the order as diffusion-assisted medium layer - silver antibacterial metal layer - diffusion-assisted medium layer -silver antibacterial metal layer on the stainless steel; however, this is only an example and not a limitation of the present disclosure.

In a preferred embodiment, the diffusion-assisted medium layer and the silver antibacterial metal layer can be coated on the surface of stainless steel at the same time by co-plated coating to further optimize the diffusion of the silver and to ensure that the silver element can diffuse more evenly into the stainless steel.

After completing the coating of the diffusion-assisted medium layer and the silver antibacterial metal layer, we can evaluate whether it is necessary to coat a protective layer on top of the silver antibacterial metal layer according to the subsequent heat treatment conditions of the finished product, wherein the protective layer is made of high melting point materials. In a specific embodiment, the protective layer is a metal layer (such as a chromium, molybdenum, tungsten, nickel, or titanium layer) or a ceramic layer (such as a nitride or oxide layer); however, these are only examples and not limitations of the present disclosure. In this way, it can prevent the volatilization of silver element in the high temperature heat treatment process, and at the same time avoid the oxidation problem caused by the small amount of oxygen remaining in the ambient atmosphere, and the protective layer can be coated by means of a method such as the aforementioned physical vapor deposition, chemical vapor deposition, electroplating, autocatalytic plating or any combination to carry out the coating. The thickness of the coating is variable, and preferably ranging from 0.05 µm to 5.00 µm; wherein if the thickness of the protective layer is less than 0.05 µm, the silver may evaporate from small defects on the surface of the plated layer, resulting in poor protection; if the protective layer thickness is over 5.00 µm, the excessive protective layer may remain on the surface of stainless steel, which needs to be removed by additional surface treatment; however, these are only examples and not limitations of the present disclosure.

S003: A heat treatment of the stainless steel is performed, so that a silver antibacterial metal is diffused into the stainless steel, and finally a silver antibacterial alloy layer is formed on the surface of stainless steel.

In an embodiment, the heat treatment is carried out in a protective atmosphere in order to reduce the oxidation of the substrate during the heat treatment, wherein the protective atmosphere can be vacuum, or an environment with nitrogen, argon, hydrogen or any combination of the above. In other embodiments, the protective atmosphere can be a reducing atmosphere, and the heat treatment may be performed at any heating rate to achieve the target temperature.

Therefore, in the heat treatment of an embodiment, the protective atmosphere is heated to 500°C or higher, and the heating time is greater than 1 min.

The temperature of the heat treatment can be adjusted according to the type, thickness or morphological structure of the steel; when the heating temperature is lower than 500 °C, the diffusion rate of the silver is extremely low, which cannot satisfy the effect of effective antibacterial depth; with the increase of the heating temperature, the diffusion rate will be increased accordingly, thus effectively extending the diffusion distance.

However, special attention should be paid to the fact that since the melting point of silver is 961 °C, when the temperature exceeds this range, too much silver may be volatilized into the environment, resulting in insufficient silver content that can be diffused into the substrate, and may cause problems such as sample adhesion and furnace contamination, etc. Therefore, when the temperature of heat treatment exceeds 800 °C, the problem of silver volatilization can be overcome by applying the protective layer as mentioned above.

The heat treatment time should be set to exceed at least 1 minute to ensure sufficient time for the antibacterial element to fully diffuse into the stainless steel, and the length of the heat treatment time can be adjusted according to the type of steel used and the thickness of the target silver antibacterial alloy layer. As the heat treatment time is prolonged, the diffusion distance of the silver antibacterial element will be increased accordingly, which will make the silver antibacterial alloy layer thicker. However, when the heat treatment time is too long, even though the diffusion distance increases, its effect gradually decreases, which will eventually lead to energy waste; therefore, it is better to set the range of the heat treatment time between 1 minute and 100 hours to achieve a good diffusion effect and resource utilization efficiency.

In an embodiment, the temperature of the stainless steel with the silver antibacterial alloy layer after the heat treatment can be reduced by natural cooling, furnace cooling, air cooling, quench or any combination of the above depending on the target organization structure to ultimately bring the temperature down to room temperature.

As to the silver antibacterial alloy layer, the silver concentration of the surface treatment material of the stainless steel gradually decreases from the surface of the steel to the same as the substrate, so there will be differences in organization and composition. During the heat treatment process, due to the low solubility of silver in the iron and chromium elements in the substrate, the silver will diffuse along the grain boundaries to the inside of the stainless steel, therefore, a high density of silver-rich organization can be observed at the grain boundaries of the surface of the stainless steel; as the depth increases, the silver-rich phase will be reduced, and the original composition, organization and properties of the stainless steel will be maintained in the substrate.

In particular, since the silver element is almost insoluble in the iron substrate, but exists in the form of precipitated phases at the grain boundaries, so that in the present disclosure, the depth of dispersion or antibacterial alloy layer thickness is determined by combining microscopic images and chemical compositional analysis to determine the deepest position where the silver precipitated phase exists. Therefore, in the present disclosure, the depth of diffusion or antimicrobial alloy layer thickness is determined by combining microscopic images and chemical composition analysis to measure the deepest position of the silver precipitation phase. Moreover, when the silver content exceeds 0.2 wt%, it can provide an excellent antibacterial effect, therefore, the effective depth of silver antibacterial alloy layer is proportional to the diffusion depth of silver. In the present disclosure, the thickness of the silver antibacterial alloy layer is measured and determined by using a scanning electron microscope (SEM) to observe the microstructure in conjunction with an energy-dispersive spectrometer (EDS) or a wavelength-dispersive X-ray spectroscopy (WDS) to analyze elements and measure the diffusion depth of the silver element.

The present disclosure is further illustrated by the following embodiments, which are provided for the illustrative purpose only and not intended to limit the scope of the present disclosure.

### [Implement Materials, Precursors and Diffusion Heat Treatment]

In an embodiment of the present disclosure, the martensitic 420J2 stainless steel (SUS 420J2) and austenitic 304L stainless steel (SUS 304L) are used to compare the differences with various different steel types used in the present disclosure, and their chemical compositions are shown in Table 1 and Table 2 below and the test samples are pre-treated as follows: First of all, the stainless steel plate is cut into the size of 20 cm length, 5 cm width and 2 mm thickness, then a sanding wheel and a nylon wheel are used to polish the surface and remove the rust spots and defects on the surface; then ultrasonic vibration is used to clean the test specimen, ensuring that the surface of the material is degreased and decontaminated, in order to form the substrate of stainless steel.

Subsequently, a diffusion-assisted medium layer and a silver antibacterial metal layer are sputtered on the test specimen by physical vapor deposition as describe above, followed by a diffusion heat treatment, wherein the detailed operational parameters for preparing the silver-containing stainless steel surface are listed in Table 3.

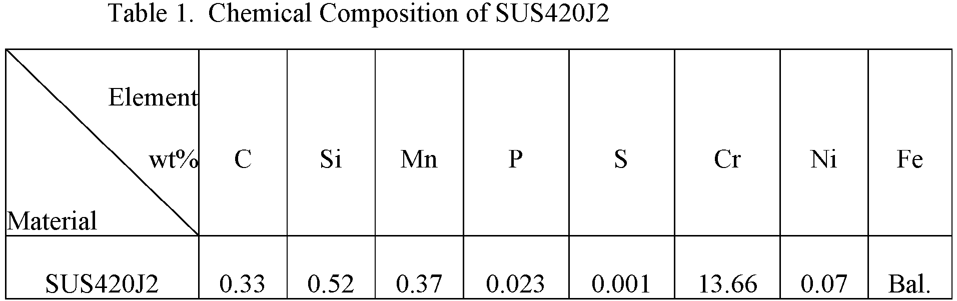

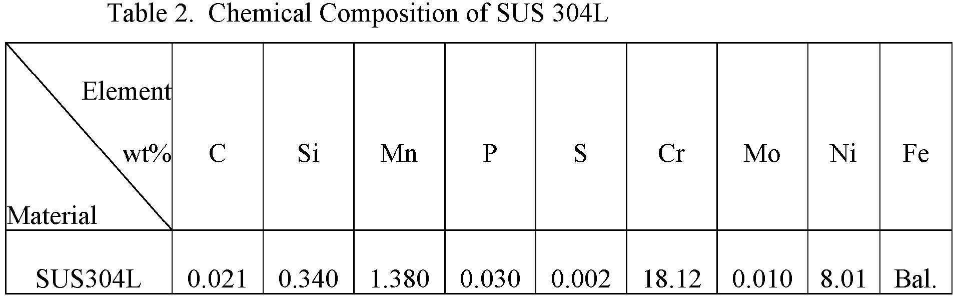

**Table 3. List of Parameter for Antibacterial Treatment of Stainless Steel**

| Sample (No. ) | Type of steel | Thickness of diffusion-assisted medium layer (µm) | Thickness of silver antibacterial metal layer (µm) | Thickness of protective layer (µm) | Maintained Temperature (°C) | Temperature Maintaining Time (hr) | Cooling Method | Tissue structure after heat treatment | Remarks |
|---|---|---|---|---|---|---|---|---|---|
| 1 | 420J2 | 0.40 | 0.40 | 0.40 | 800 | 2 | Furnace cooling | Ferric stainless steel | This embodiment |
| 2 | 304L | 0.40 | 0.40 | 0.40 | 800 | 2 | Furnace cooling | Austenitic stainless steel | This embodiment |
| 3 | 304L | 0.40 | 0.40 | 0.40 | 900 | 2 | Furnace cooling | Austenitic stainless steel | This embodiment |
| 4 | 304L | 0.50 | 0.40 | 0.40 | 900 | 2 | Furnace cooling | Austenitic stainless steel | This embodiment |
| 5 | 304L | 0.60 | 0.40 | 0.40 | 900 | 2 | Furnace cooling | Austenitic stainless steel | This embodiment |
| 6 | 420J2 | 0.40 | 0.40 | 0.40 | 900 | 2 | Furnace cooling | Ferric stainless steel | This embodiment |
| 7 | 304L | 0.40 | 0.40 | 0.40 | 900 | 5 | Furnace cooling | Austenitic stainless steel | This embodiment |
| 8 | 420J2 | 0.30 | 0.40 | 0.40 | 1050 | 0.5 | Quench | Martensitic stainless steel | This embodiment |
| 9 | 420J2 | 0.40 | 0.40 | 0.40 | 1050 | 0.5 | Quench | Martensitic stainless steel | This embodiment |
| 10 | 420J2 | 0 | 0.40 | 0.40 | 800 | 2 | Furnace cooling | Ferric stainless steel | Comparative example |
| 11 | 304L | 0 | 0.40 | 0 | 800 | 2 | Furnace cooling | austenitic stainless steel | Comparative example |
| 12 | 420J2 | 0 | 0 | 0 | 1050 | 0.5 | Quench | martensitic stainless steel | Comparative example |
| 13 | 304L | 0 | 0 | 0 | 900 | 2 | Furnace cooling | austenitic stainless steel | Comparative example |

### [Effect of Diffusion-Assisted Medium Layer]

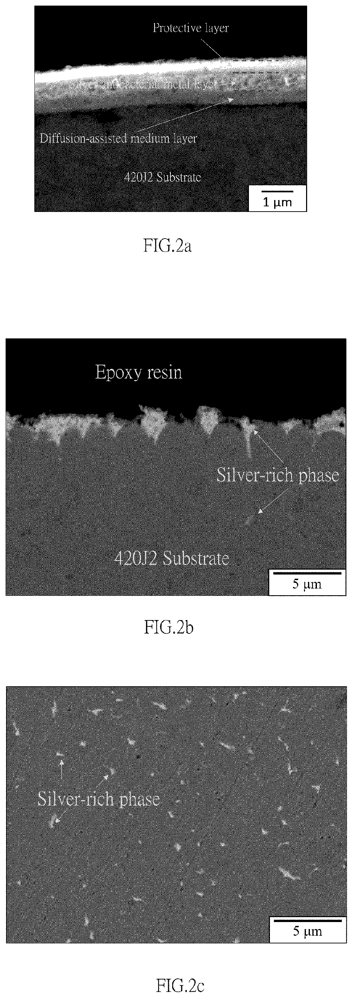

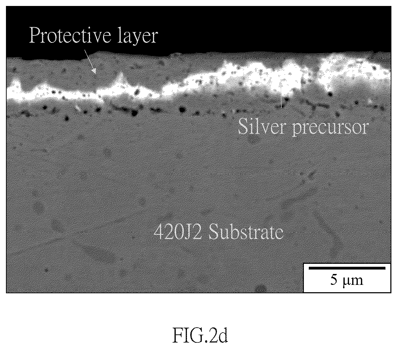

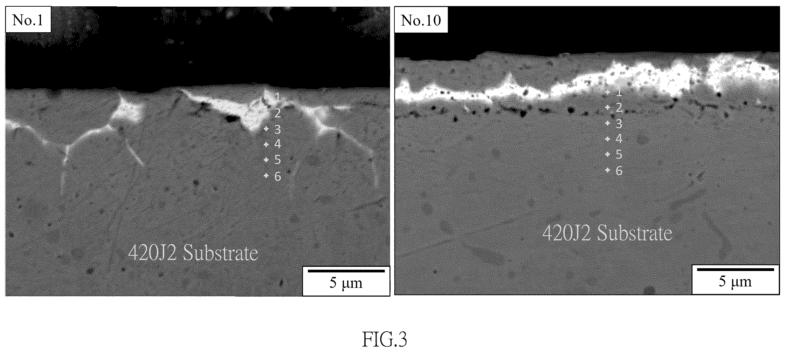

With reference to FIG. 2a for the cross-sectional microstructure of Sample No. 1 after sputtering, the precursors are stacked in layers on the surface of the 420J2 substrate, including the diffusion-assisted medium layer, silver antibacterial metal layer and protective layer, and the residues are removed after heat treatment and slight grinding, and FIG. 2b is a SEM cross-sectional image showing that the silver-rich phase is obviously distributed on the grain boundaries of the stainless steel, which means that the silver may diffuse to the substrate surface through the grain boundaries. The silver-rich phase can be recognized at a depth of about 6-7 µm from the substrate surface, confirming the success of the present disclosure in diffusing silver into the stainless steel substrate. FIG. 2c is a SEM image showing that the silver-rich phase is dispersed and embedded in the surface of stainless steel, indicating that the silver has indeed diffused into the stainless steel, rather than just adhering to the surface. As for the sample without the diffusion-assisted medium treatment (Sample No. 10 serves as a control group), no silver-rich phase is observed in the SEM cross-sectional image after heat treatment, as shown in FIG. 2d, and the EDS compositional analysis results of organization1 and No. 10 are compared as shown in Tables 4 and 5. Further a comparison of the EDS compositions of the samples No. 1 and No. 10, as shown in FIG. 3, the compositions of the two samples at each point are shown in Tables 4 and 5 below.

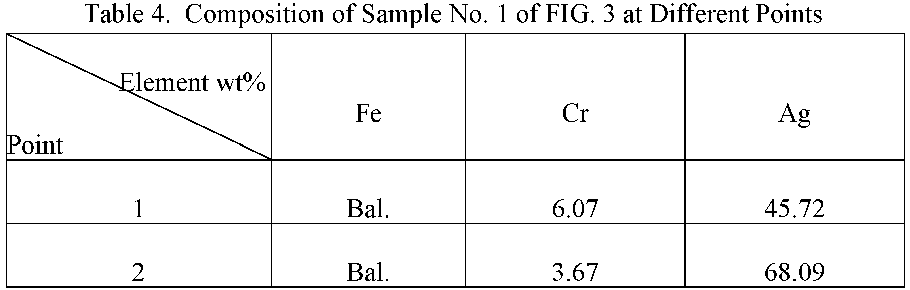

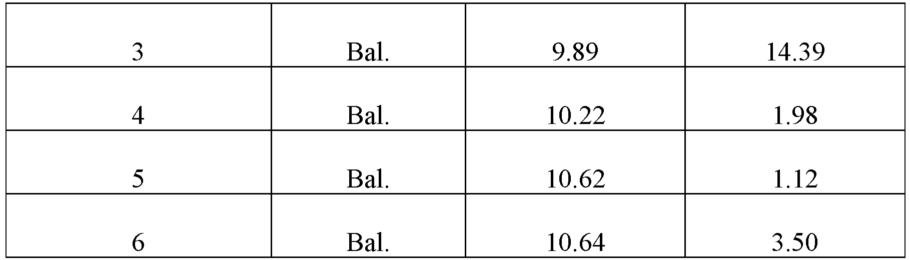

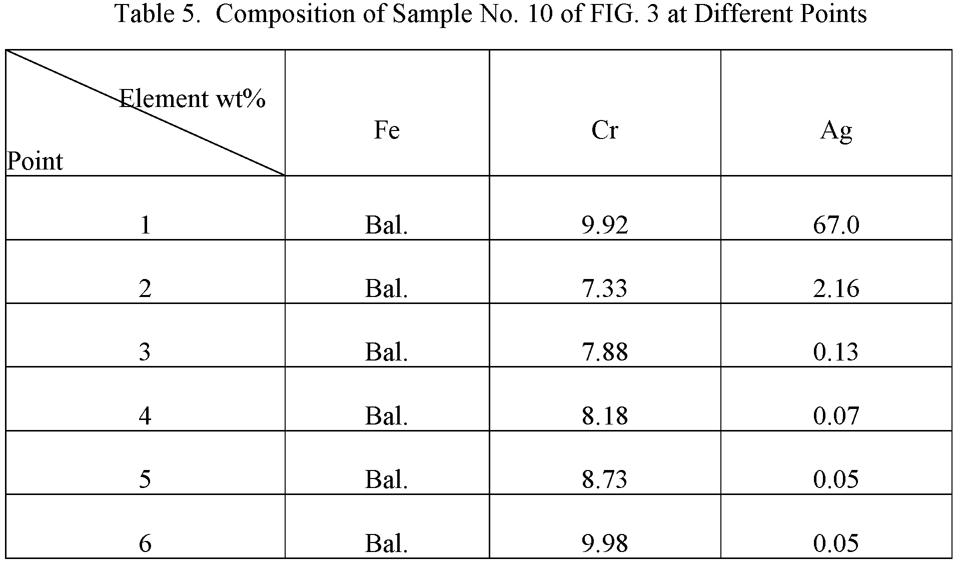

From the data, it is found that the light-colored area of Sample No. 1 is silver-rich, and after penetrating deep into the substrate along the silver-rich area, a considerable amount of silver could still be identified, showing that the silver has successfully diffused into the inside of the stainless steel substrate, and the diffusion distance is up to 6.09 µm; and Sample No. 10, which has not undergone the diffusion-assisted medium treatment, does not have obvious silver-rich organization in the substrate, and the composition analysis has not detected an effective silver signal, indicating that it is difficult to diffuse the silver element into the substrate without the use of the diffusion-assisted medium layer.

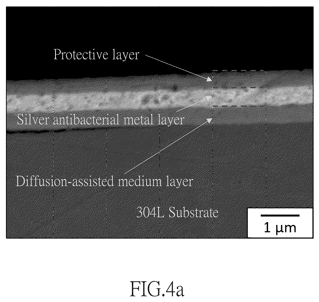

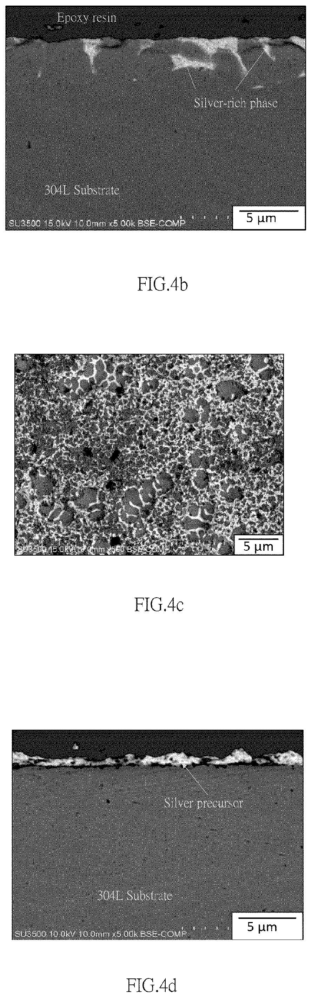

FIG. 4a shows that the cross-sectional microstructure of Sample No. 2 using austenitic 304L stainless steel as substrate after sputtering, and the precursors are also stacked on the substrate surface in a layered structure. After heat treatment, the SEM cross-sectional image is as shown in FIG. 4b, and the silver-rich phase is also distributed along the grain boundaries of the stainless steel. After the sample has been heat treated, its SEM cross-sectional image is shown in FIG. 4b. The silver-rich sample is distributed along the grain boundaries of the stainless steel, and the existence of the silver-rich phase can still be observed in the depth range of 5-6 µm from the substrate surface. The SEM image of the sample surface is as shown in FIG. 4c. Since the surface is not ground, the presence of silver-rich phases distributed along the grain boundaries, forming a distinct reticulated structure which indicates that their distribution is closely related to the crystalline organization of the substrate. As for the sample without diffusion-assisted medium treatment (No. 11 serves as a control group), no diffusion of the silver-rich phase into the substrate is observed in the cross-sectional SEM image after heat treatment, as shown in FIG. 4d.

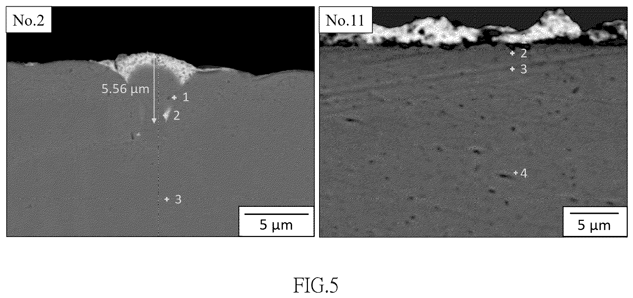

Further, the EDS compositional analysis results of two test specimens of the samples No. 2 and No. 11 are compared as shown in FIG. 5 and Tables 6 and 7 below, the light-colored area in Sample No. 2 substrate shows a high proportion of silver content, confirming that the area is a silver-rich structure, and the diffusion distance can be observed from the image to reach 5.56 µm; on the other hand, Sample No. 11 without assisted medium treatment does not show any silver diffusion from the substrate grain boundaries to the interior, confirming that the use of diffusion-assisted medium layer is crucial for the silver diffusion treatment.

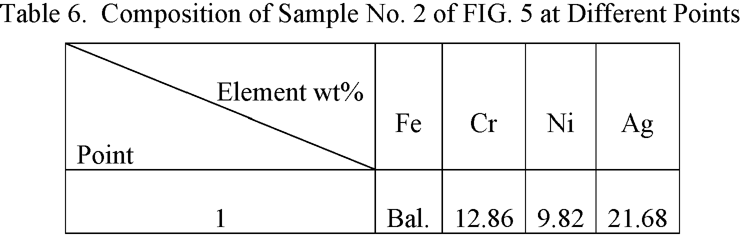

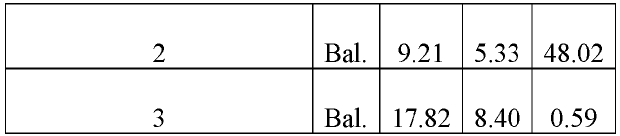

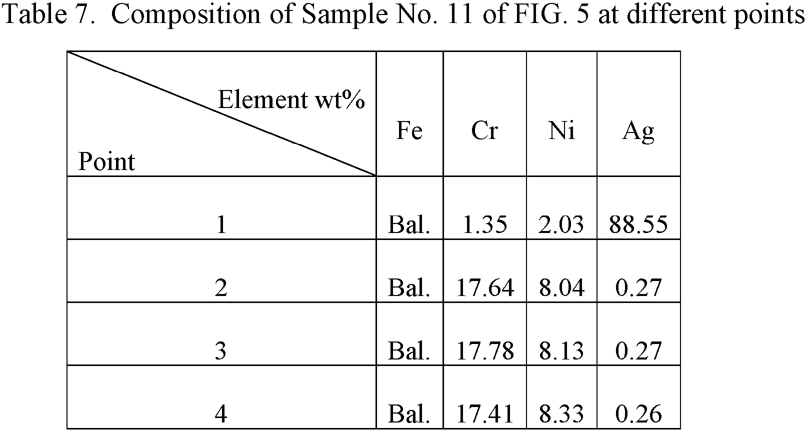

According to the aforementioned results, the present disclosure can indeed be applied to the diffusion-assisted medium layer, so that the silver element can be successfully diffused into stainless steel substrate and the present disclosure can successfully achieve silver diffusion in both types of martensitic (No. 1) and austenitic (No. 2) stainless steel, which establishes the wide versatility of the present disclosure.

### [Effect of Thickness of Diffusion-assisted Medium Layer]

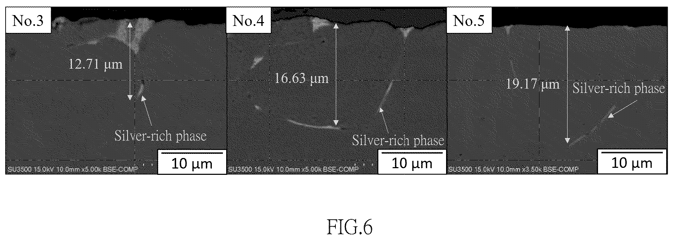

With reference to FIG. 6 for the comparison of the effect of different thickness of the diffusion-assisted medium layer on silver diffusion, the samples No. 3, No. 4 and No. 5 are all made of 304L stainless steel as substrate, treated with different thickness of diffusion-assisted medium layer, then the silver antibacterial metal layer and protective layer are sputtered, and the samples are analyzed by SEM/EDS after diffusion heat treatment. The analysis results show that the silver diffusion depth is 12.71 µm for Sample No. 3, 16.63 µm for Sample No. 4, and 19.17 µm for Sample No. 5, which indicates that the silver diffusion depth in stainless steel base material increases with the increase of the thickness of the diffusion-assisted medium layer. The above results show that by adjusting the thickness of the diffusion-assisted medium layer, the diffusion depth of silver in the substrate can be significantly affected. This result shows that by controlling the thickness of the diffusion-assisted medium layer, the depth of diffusion of silver can be precisely adjusted according to the requirements of the subsequent finished product, which will provide more flexibility for subsequent and future applications.

### [Effect of Heat Treatment Conditions to Tissue Structure]

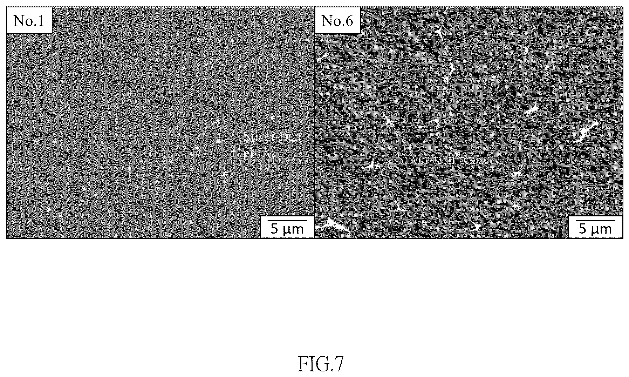

With reference to FIG. 7 for the effect of different heat treatment conditions on the silver diffusion distribution, the samples No. 1 and No. 6 of this embodiment are sputtered with the same proportion of precursors using 420J2 as substrate, and are subjected to heat treatment at 800 °C and 900 °C for 2 hours, respectively. In the SEM surface images of the samples, the grain size of Sample No. 1 is smaller and the ratio of grain boundaries is higher. As a result, the silver-rich phases form a granular structure and are primarily distributed along the grain boundaries; whereas Sample No. 6, which has undergone a higher temperature heat treatment, exhibits larger grain size. This facilitates the aggregation of silver-rich phases, resulting in their mesh-like distribution along the grain boundaries

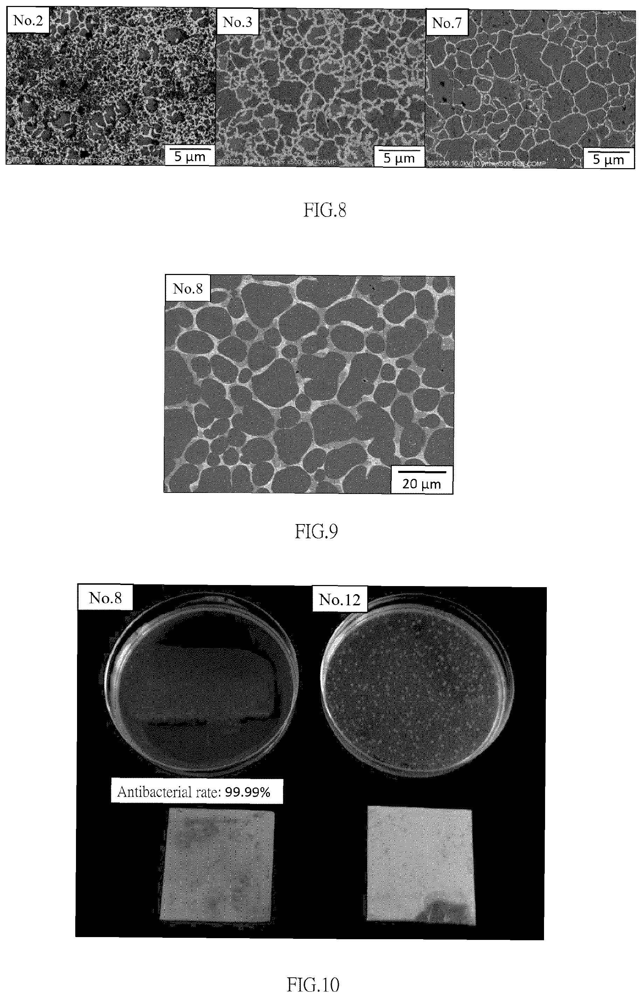

Compared with the result of using the 304L as the test substrate, the results in FIG. 8 show that Sample No. 2 with the heat treatment at 800 °C for 2 hours has a smaller grain structure, a large number of silver-rich phases distributed on the surface, and a porous structure observed in certain areas; When the temperature is raised and maintained at 900°C for 2 hours, the grain size of Sample No. 3 increases, the silver-rich phases are more evenly distributed on the grain boundaries, and the surface becomes flatter, with no porous structures observed, which means that the silver diffuses more uniformly into the substrate; while in Sample No. 7, which is maintained at 900°C for 5 hours, the silver-rich phases on the grain boundaries show a finer morphology, indicating that a greater amount of silver has diffused into the substrate. Additionally, the silver-rich phase exhibit high consistency with the stainless steel substrate, forming a stable mesh-like structure.

In summary of the foregoing results, it is evident that the present invention can effectively control the distribution and morphology of the silver-rich phase by adjusting the heat treatment parameters to meet diverse application requirements. For example, 304L stainless steel is widely used in household appliances, can have its silver-rich phases distribution tailored for specific manufacturing processes. For products that require plasticizing, such as cups, cans, etc., a higher surface concentration of silver-rich phases is crucial to retain sufficient silver content after deformation. Conversely, flat products which do not undergo further processing, such as cutting boards and refrigerator liners, can have a lower proportion of silver-rich phases to enhance corrosion resistance.

### [Antibacterial Test]

The antimicrobial property test of this embodiment was conducted with reference to the JIS Z2801 standard, using ATCC 8739 E. coli as the test strain, and the bacterial solution with a concentration of 2.5 × 10⁵ ~ 10⁶ CFU/ml was inoculated into the antibacterial-treated and non-treated stainless steel specimen, and the testing area was controlled to 40 mm × 40 mm, at a temperature of 37°C for 24 hours. After the bacterial solution was washed off with phosphate buffered saline (PBS), the number of colonies was counted using the standard plate count method, and the number of colonies of the two specimens was calculated according to the following mathematical equation 1 to obtain the antibacterial rate of the antibacterial-treated specimens. Antibacterial rate = (Number of colonies on untreated stainless steel test specimen - Number of colonies on antimicrobial-treated stainless steel test specimen) / Number of colonies on untreated stainless steel test specimen ×100%.

Since 420J2 is a type of cutting tool steel, it is typically quench-hardened in practical applications, so the quenched Sample No. 8 was selected for the antibacterial test, and Sample No. 12 was selected as the untreated control group; Sample No. 8 was first ground with #2000 sandpaper, and then polished with aluminum oxide powder. The microscopic image of the polished surface is shown in FIG. 9. The antibacterial test was performed following the aforementioned procedure, and the test was repeated for 3 times to ensure the reproducibility. The results of the antibacterial test are shown in FIG. 10, the antibacterial rate of Sample No. 8 reaches 99.99%, which shows that the surface of the material produces the antibacterial effect and confirms that the present disclosure is successfully applied to martensitic steels.

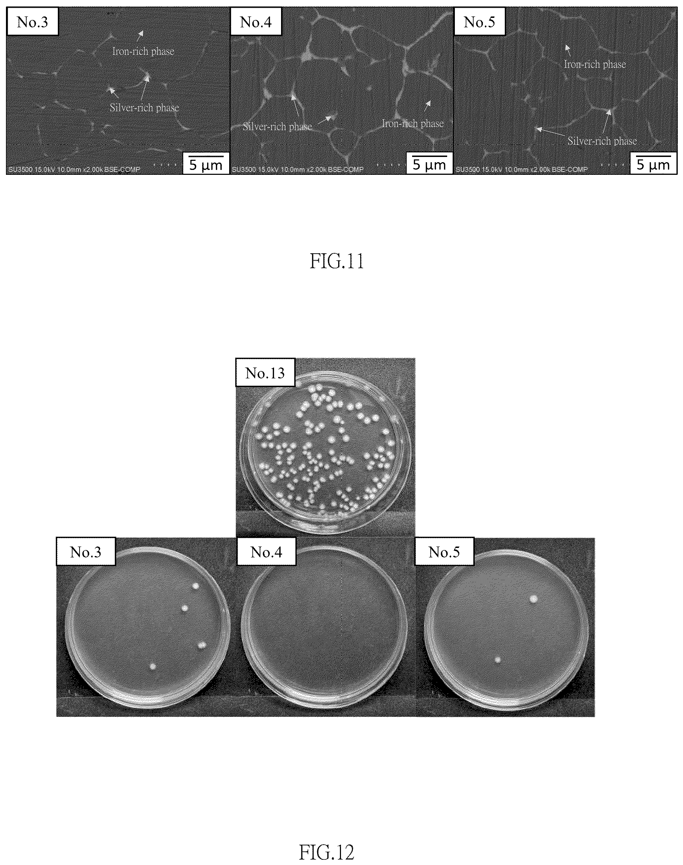

For the 304L stainless steel, the samples No. 3, No. 4 and No. 5 were selected for the antibacterial test, and Sample No. 13 was used as the untreated control group; the samples were initially ground with #2000 sandpaper to ensure uniform surface roughness, and the individual ground surfaces are shown in FIG. 11. The antibacterial test was performed following the aforementioned procedure and repeated 3 times to ensure the reproducibility. The test results, shown in FIG. 12 and Table 8 below, indicate that the antibacterial rate is 97.45% for Sample No. 3, 99.70% for Sample No. 4, and 99.46% for Sample No. 5. These data show that all the samples exhibit excellent antibacterial effects, and the surface maintains excellent antibacterial properties after diffusion. By increasing the proportion of the diffusion-assisted medium layer to enhance the depth of silver diffusion, the surface after diffusion still maintain superior antibacterial performance, confirming the remarkable antibacterial ability of the silver element. In addition, the reproducibility test of the antibacterial properties can further prove the stability and reliability of the present disclosure, highlighting its potential for application in antibacterial products.

**Table 8**

| Sample | Antibacterial Rate (%) |
|---|---|
| No. 3 | 97.45±1.51 |
| No. 4 | 99.70±0.38 |
| No. 5 | 99.46±0.40 |

### Corrosion Resistance Test

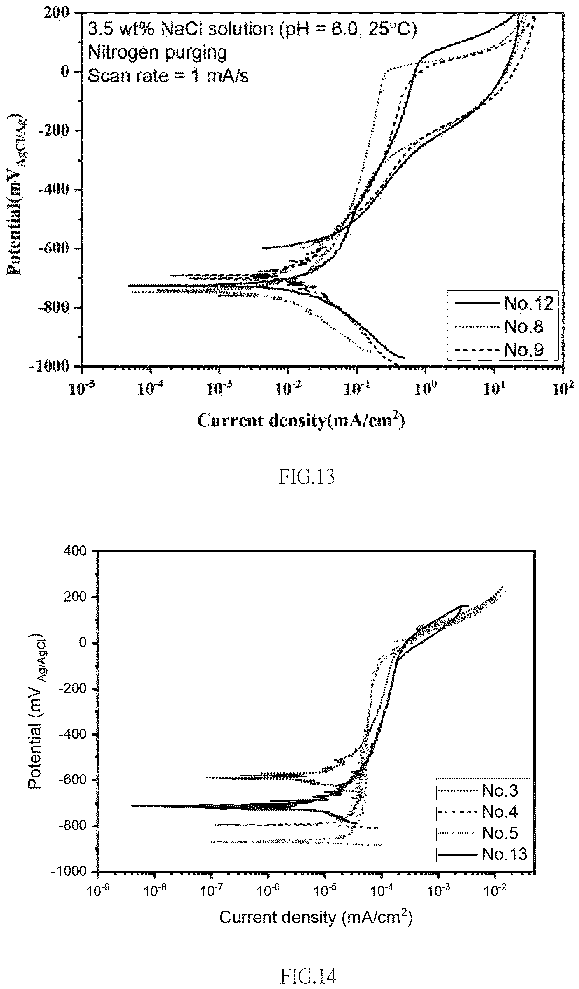

The corrosion resistance was measured and analyzed using cyclic polarization curve, with the testing solution was a 3.5 wt% aqueous NaCl solution deoxygenated by nitrogen at 25 °C; Since 420J2 is a type of cutting tool steel, it is typically quench-hardened in practical applications, and the corrosion resistance between annealed and quenched structures is significantly different, therefore, the samples in this test were all subjected to rapid air cooling; Sample No. 8 and sample No. 7 of the 420J2 with different thickness of the diffusion-assisted medium layer were selected for the test., and a general 420J2 sample No. 12 was selected as the control group; the hardness of all three samples reached HRC 52 after quench treatment, confirming the successful hardening of the material. The results of the corrosion tests are shown in FIG. 13 and Table 9 below, indicating that the passivation current density of the samples was lower than that of Sample No. 12. This suggests that the silver-containing surface passivation film is more stable and effectively reduces the corrosion rate.

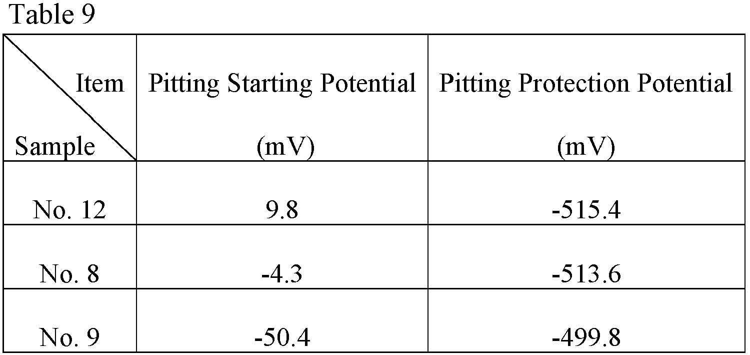

For the 304L stainless steel, samples No. 3, No. 4 and No. 5 with varying thickness of the assisted medium layer were selected for testing, while untreated 304L stainless steel sample No. 13 served as the control group. The test results are shown in FIG. 14, indicate a decrease in passivation current density for all three samples. This observation is consistent with the behavior of the aforementioned 420J2 substrate, and demonstrates that the silver-containing surface passivation film is more stable.

In summation of the aforementioned experiments, the phenomenon of reduced passivation current density was observed in stainless steel materials (such as 304L and 420J2) treated with silver infiltration and diffusion, which means that silver effectively enhances the stability of the surface passivation film. In other words, diffusing silver onto the surface of stainless steel through the present disclosure, not only provides the stainless steel antibacterial ability, but also further effectively enhances the corrosion resistance by improving the stability and self-repairing ability of the passivation film.

### [Metal Dissolution Test]

Stainless steel is widely used in a variety of household products, especially the 300 series austenitic stainless steel is more commonly used in food containers; therefore, when the present disclosure is applied to the manufacture of food or drinking water containers, it is necessary to ensure that the silver element dissolution meets the safety regulations. This test was conducted in accordance with ASTM D5673, in which deionized water was applied to the surface of the samples No. 3, No. 4 and No. 5, and the samples were sealed in a Petri dish for 7 days. The amount of dissolved silver ions was subsequently measured by Inductively Coupled Plasma Mass Spectrometry (ICP-MS). The test results are shown in Table 10 below; firstly, a standard sample with a silver ion concentration of 0.100 ppm was used for calibration, and the effective quantitative concentration range after calibration was determined to be from 0.01 to 1.00 ppm. Subsequently, three sets of the samples were tested, and the data showed that the silver ion release of all three sets was less than 0.01 ppm, which is below the quantitative range and determined to be not detected (ND). Therefore, according to ASTM D5673, the silver ion release of the present disclosure was less than 0.05 ppm, which falls within the safe range; The test results demonstrate that the present disclosure can maintain antibacterial activity in the range of 0.01 to 1.00 ppm while ensuring the safety of food and drinking water.

**Table 10. Test Results of Silver Ion Release of 304L after Silver Diffusion, where the diffusion-assisted medium layer thickness of the samples is 0.40 µm for Sample No. 3, 0.50 µm for Sample No. 4, and 0.60 µm for Sample No. 5.**

| Sample No. | Actual Concentration (ppm) | Measured Concentration (ppm) | Relative Standard Deviation (RSD) (%) |
|---|---|---|---|
| QC (Calibration Sample ) | 0.100 | 0.0998 | 0.77% |
| No. 3 | | ND (<0.01ppm) | |
| No. 4 | | ND (<0.01ppm) | |
| No. 5 | | ND (<0.01ppm) | |

In summation of the description above, the technical means disclosed in the present disclosure can effectively overcome the problems of the related art and achieve the expected purpose and effect, and has not been published or used in public before application, and complies with other patent application requirements, and thus it is submitted to the Patent and Trademark Office for review and granting of the commensurate patent rights.

While the disclosure has been described by way of example and in terms of preferred embodiments, it is to be understood that the disclosure is not limited thereto. To the contrary, it is intended to cover various modifications and similar arrangements and procedures, and the scope of the appended claims therefore should be accorded the broadest interpretation so as to encompass all such modifications and similar arrangements and procedures.

## Claims

1. A method for preparing antibacterial silver-containing stainless steel through surface alloying, comprising:
coating at least one diffusion-assisted medium layer on a surface of stainless steel;
coating at least one silver-containing antibacterial metal layer on the diffusion-assisted medium layer, wherein the silver concentration of the silver antibacterial metal layer is at least 0.2 wt%; and
performing heat treatment on the stainless steel to diffuse a silver antibacterial metal into the stainless steel.

2. The method for preparing antibacterial silver-containing stainless steel through surface alloying according to claim 1, wherein the diffusion-assisted medium layer has a thickness falling within a range from 0.05 µm to 5.00 µm.

3. The method for preparing antibacterial silver-containing stainless steel through surface alloying according to claim 1, wherein the silver antibacterial metal layer has a thickness falling within a range from 0.02 µm to 2.00 µm.

4. The method for preparing antibacterial silver-containing stainless steel through surface alloying according to claim 1, wherein the heat treatment heats up to a temperature of 500°C or higher in a protective atmosphere, and heating time is greater than 1 min., and the temperature drops to room temperature after the completion of the heat treatment.

5. The method for preparing antibacterial silver-containing stainless steel through surface alloying according to claim 4, wherein after the heat treatment, the temperature drops to room temperature by furnace cooling, air cooling, quench, or any combination of the above.

6. The method for preparing antibacterial silver-containing stainless steel through surface alloying according to claim 1, wherein the diffusion-assisted medium layer is copper, cobalt, nickel, zinc, molybdenum, chromium, titanium, or any combination of the above.

7. The method for preparing antibacterial silver-containing stainless steel through surface alloying according to claim 1, wherein the stainless steel is ferritic stainless steel, austenitic stainless steel, martensitic stainless steel, duplex stainless steel, or any combination of the above.

8. The method for preparing antibacterial silver-containing stainless steel through surface alloying according to claim 1, wherein the diffusion-assisted medium layer or the silver antibacterial metal layer is coated by physical vapor deposition, chemical vapor deposition, electroplating, autocatalytic plating, or any combination of the above.

9. The method for preparing antibacterial silver-containing stainless steel through surface alloying according to claim 1, wherein the diffusion-assisted medium layer and the silver antibacterial metal layer are coated on the surface of stainless steel by multi-layer stacking.

10. The method for preparing antibacterial silver-containing stainless steel through surface alloying according to claim 1, wherein the diffusion-assisted medium layer and the silver antibacterial metal layer are coated on the surface of stainless steel simultaneously by co-plated coating.
